Europäisches Patentamt

European Patent Office

Office européen des brevets

(11) Publication number: **0 471 202 A2**

# EUROPEAN PATENT APPLICATION

(21) Application number: **91112055.8**

(22) Date of filing: **18.07.91**

(51) Int. Cl.⁵: **B23K 26/06**

(30) Priority: **27.07.90 JP 200867/90**

(43) Date of publication of application:
**19.02.92 Bulletin 92/08**

(84) Designated Contracting States:
**DE FR GB**

(71) Applicant: **ADVANTEST CORPORATION**
**32-1, Asahi-cho 1-chome**
**Nerima-Ku Tokyo(JP)**

(72) Inventor: **Akira, Goishi**
**15-10, Minamicho**
**Kazo-shi, Saitama(JP)**
Inventor: **Toshiyuki, Ihara**
**1-17-39, Sakuracho**
**Gyoda-shi, Saitama(JP)**

(74) Representative: **Blumbach Weser Bergen**
**Kramer Zwirner Hoffmann Patentanwälte**
**Radeckestrasse 43**
**W-8000 München 60(DE)**

(54) Laser machining device with selectability of beam shape.

(57) A liquid crystal device (17) is disposed on an optical path for irradiating a workpiece (24) with a laser beam from a laser (11). The laser beam is applied via the liquid crystal device to the workpiece after the diameter of the laser beam is enlarged by an expander (14). A beam cross-sectional pattern, which defines desired configuration and a desired intensity distribution of the laser beam, is selectively displayed on the liquid crystal device.

FIG. 4

EP 0 471 202 A2

## BACKGROUND OF THE INVENTION

The present invention relates to a laser machining device for use with, for example, a memory repair machine which isolates a failing memory cell from a semiconductor memory by cutting the associated link in the memory wafer with a laser beam, or a laser trimming machine which removes a part of a thin film resistor with a laser beam to adjust its resistance value. More particularly, the invention is directed to a laser machining device which is of the type wherein a laser beam from a laser beam-source is condensed by an optical system for incidence to a workpiece at a specified position for machining it.

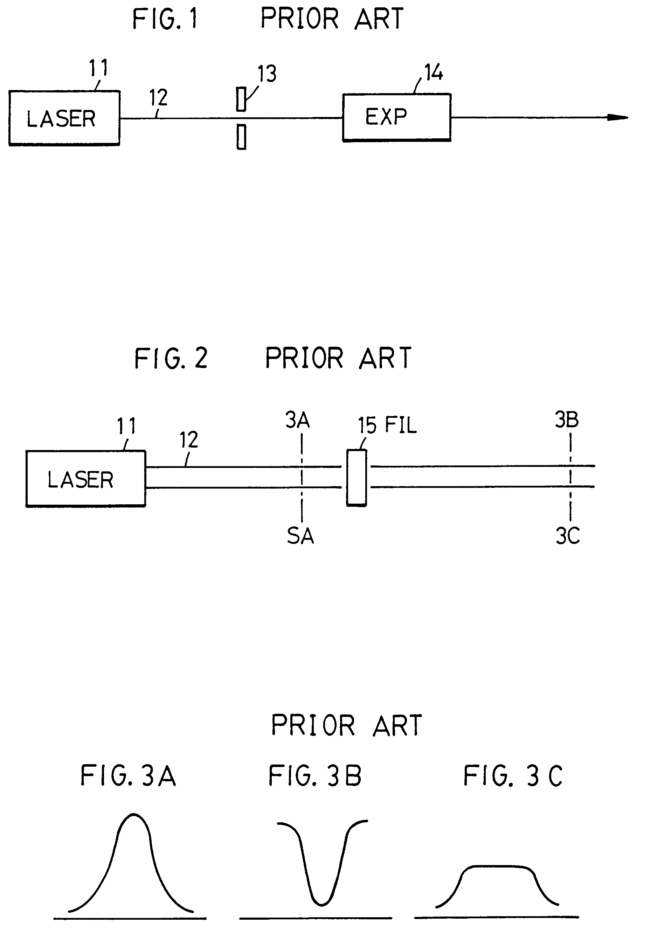

As shown in Fig. 1, in the case of changing the cross-sectional configuration and thickness of a laser beam in this kind of device heretofore employed, a laser beam 12 emitted from a laser beam-source 11 is guided to pass through a diaphragm 13 to define or control the cross-sectional configuration of the beam 12 by the shape of the diaphragm 13, and then the laser beam 12 is guided to pass through an expander 14 made up of a combination of lenses, by which the diameter (or thickness) of the laser beam 12 is controlled.

It is customary in the prior art to change the shape of the cross-section of the laser beam 12 by exchanging the diaphragm 13 with a desired one, to control the intensity distribution of the laser beam 12 at the point of incidence to the surface of the workpiece by changing the area of the aperture of the diaphragm 13, that is, by controlling the aperture opening, and to adjust the thickness (or diameter) of the laser beam 12 by shifting the expander 14 axially thereof or by exchanging the expander 14 with a desired one.

To control the intensity distribution of the laser 12 in its cross-section, a filter 15 whose transmittance differs throughout it is disposed in the path of the laser beam 12 as shown in Fig. 2. For example, in the case where the intensity distribution of the laser beam 12 in its cross-section 3A-3A prior to the incidence to the filter 15 is a relatively step-mountain-shaped profile (so-called Gaussian curve) as depicted in Fig. 3A and the transmittance of the filter 15 is low at the axis of the laser beam 12 but high at the periphery thereof as shown in Fig. 3B, the intensity distribution of the laser beam 12 in its cross-section 3C-3C after the passage through the filter 15 is such as shown in Fig. 3C, wherein the intensity of the laser beam 12 is substantially uniform over the entire area of its cross-section.

For example, in the case of cutting a band-shaped link, the use of a laser beam of an elliptic cross-section with the major axis perpendicular to the lengthwise direction of the link will ensure the cutting of the link, even if the laser beam is somewhat out of position in the widthwise direction of the link; hence, the positioning of the laser beam is easy in this instance. In the case of cutting a link extending perpendicularly to the above-mentioned one, it is preferable to turn the laser beam 90 degrees about its axis correspondingly, that is, to change the cross-sectional configuration of the laser beam so that the major axis of its elliptic cross-section lies at right angles to the lengthwise direction of the link to be cut. When the intensity of the laser beam is too high in the case of cutting a selected layer or layers of a multilayer semiconductor device, there is a possibility that the laser beam extends past the selected layer or layers and hence impairs the underlying layer or layers, making the device defective. On the other hand, when the intensity of the laser beam is too low, there is the possibility that the material to be cut is not sufficiently vaporized but is spattered all around as fine particles, deteriorating the insulating property of the semiconductor device and hence impairing its reliability.

No high-speed operation can be expected of the prior art in automatically changing the cross-section configuration or thickness of the laser beam, because it involves an exchange of the diaphragm 13, mechanical control of its aperture opening and an exchange of the expander 14 and mechanical control by its translation. Similarly, arbitrary control of the intensity distribution of the laser beam calls for the preparation of many kinds of filters and a selective exchange of them to meet individual requirements. The exchange procedure is troublesome and the preparation of many kinds of filters is also cumbersome.

Consequently, an exchange of the filter 15 with a desired one in the course of cutting in one IC chip consumes much time, inevitably impairing the overall machining efficiency. Likewise, in the case where the kind of an IC element to be machined is changed in the course of laser beam machining and the cross-sectional configuration and thickness of the laser beam are changed accordingly, exchanges of the diaphragm 13 and the expander 14 after stopping the operation of the entire system involves time-consuming initial setting of the optical system such as alignment of its optical elements ---this also constitutes a serious obstacle to efficient laser machining.

## SUMMARY OF THE INVENTION

It is therefore an object of the present invention to provide a laser machining device which allows ease in changing the shape and intensity distribution of the laser beam for machining.

According to the present invention, a liquid crystal device is disposed in the path of a laser beam, for selectively displaying a cross-sectional pattern of the laser beam which defines its cross-sectional configuration and amount of transmission through the liquid crystal device.

BRIEF DESCRIPTION OF THE DRAWINGS

Fig. 1 is a diagram schematically showing a section for controlling the cross-sectional configuration of a laser beam in a conventional device;

Fig. 2 is a diagram schematically showing a section for controlling the intensity distribution of the laser beam in the conventional device;

Fig. 3A is a diagram schematically showing the intensity distribution of the laser beam in its cross-section taken of the line 3A-3A in Fig. 2;

Fig. 3B is a diagram schematically showing the transmittance distribution of a filter used in Fig. 2;

Fig. 3C is a diagram schematically showing the intensity distribution of the laser beam in its cross-section taken on the line 3C-3C in Fig. 2;

Fig. 4 is a block diagram illustrating an embodiment of the present invention;

Fig. 5 is a diagram schematically showing an example of a pixel arrangement pattern of a liquid crystal device 17 used in the embodiment depicted in Fig. 4;

Fig. 6A is a diagram schematically showing an example of a cross-sectional pattern of a beam which is displayed on the liquid crystal device;

Fig. 6B is a diagram schematically showing another example of the cross-sectional pattern of the beam;

Fig. 6C is a diagram schematically showing still another example of the cross-sectional pattern of the beam;

Fig. 7A is a diagram showing the relationship between a shape of the laser beam and the link cutting operation;

Fig. 7B is a diagram showing the relationship between another shape of the beam and the link cutting operation; and

Fig. 8 is a block diagram illustrating the constructions of a liquid crystal control circuit 19 and a drive circuit 21 in the Fig. 4 embodiment.

DESCRIPTION OF THE PREFERRED EMBODIMENTS

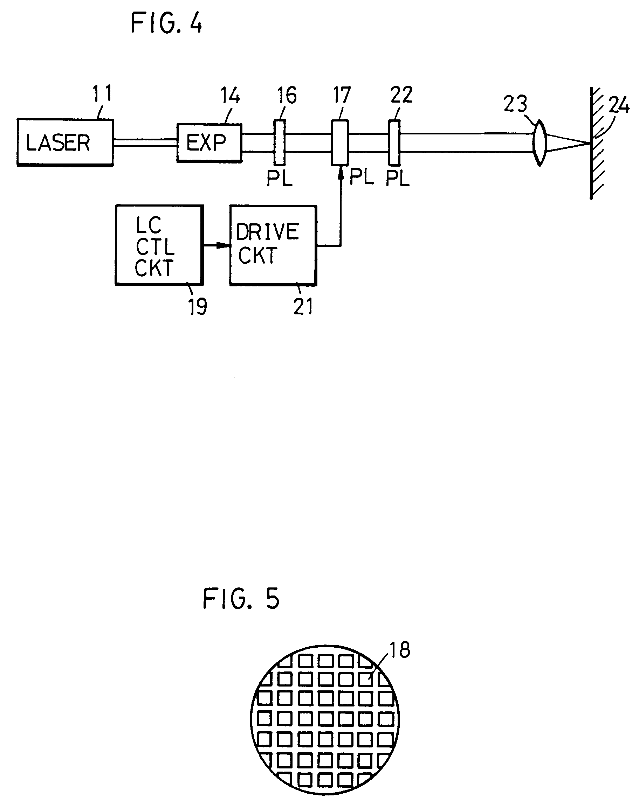

Fig. 4 illustrates in block form an embodiment of the present invention. The laser beam 12 emitted from the laser 11 is provided, if necessary, to the expander 14, by which its diameter is expanded, and the laser beam emitted from the expander 14 is linearly polarized by a polarizing plate 16, from which the linearly polarized laser beam is incident to a liquid crystal device 17. The liquid crystal device 17 is a device by which the amount of transmission therethrough of the laser beam can selectively controlled in the form of a pattern. In the Fig. 4 embodiment the liquid crystal device 17 is an active dot matrix liquid crystal device of the type that a thin film transistor is provided as a switching element in association with each pixel. For example, as shown in Fig. 5, square pixels 18 are arranged in a matrix form and the pixels 18 can be selectively driven by a liquid crystal control circuit 19 via a drive circuit 21. That is, the direction of polarization of light incident to the liquid crystal device 17 is turned 90 degrees, held unturned, or turned an angle in the range of between 0 and 90 degrees through control of twisted nematic liquid crystal for each pixel 18, by which the quantity of light which is permitted of the passage through the liquid crystal element 17 and a polarizing plate 22 can be controlled. The laser beam having passed through the liquid crystal element 17 is incident to the polarizing plate 22, which permits the passage therethrough of only light of the corresponding polarized component, and the laser beam having thus transmitted through the polarizing plate 22 is converged by a convergent lens 23 for incidence to a specified position on a workpiece 24. The polarizing plates 16 and 22 and the liquid crystal element 17 perform the same operation as does an ordinary transmission type liquid crystal display panel.

For example, in the case of repairing a defective cell or wiring of a memory IC or liquid crystal display by using, as the laser 11, a YAG laser which generates infrared pulsed laser light of a wavelength 1 $\mu$m and an energy 0.7 to 2 $\mu$J, the laser beam for irradiating the workpiece 24 is converged by the convergent lens 23 to a diameter of 5 to 10 $\mu$m ($1/e^2$). The energy density of the thus converged laser beam is around 30 kJ/m$^2$. Assuming that the diameter of the laser beam passing through the liquid crystal device 17 is in the range of 5 to 10 mm, the energy density of the beam is approximately one-millionth that on the workpiece 24 and the liquid crystal device 17 is not likely to be damaged by the laser beam. Accordingly, if the laser beam 12 is 0.5 to 1.5 mm in diameter when it is emitted from the laser 11, then the beam diameter needs only to be enlarged about 10 times by the expander 14.

With such an arrangement as shown in Fig. 4, the cross-section of the laser beam 12 can be given an arbitrary shape, by selectively controlling desired ones of the pixels 18 of the liquid crystal element 17 to be transparent or opaque to light. In addition to this, the quantity of light which passes through the liquid crystal device 17 can be controlled arbitrarily by controlling the drive voltage which is applied to the pixels 18 being held transparent. That is, the light transmittance of twisted nematic liquid crystal, for instance, varies substantially linearly between voltages making the liquid crystal transparent and opaque, respectively. Thus, the twisted nematic liquid crystal acts as a filter whose transmittance varies for each pixel 18.

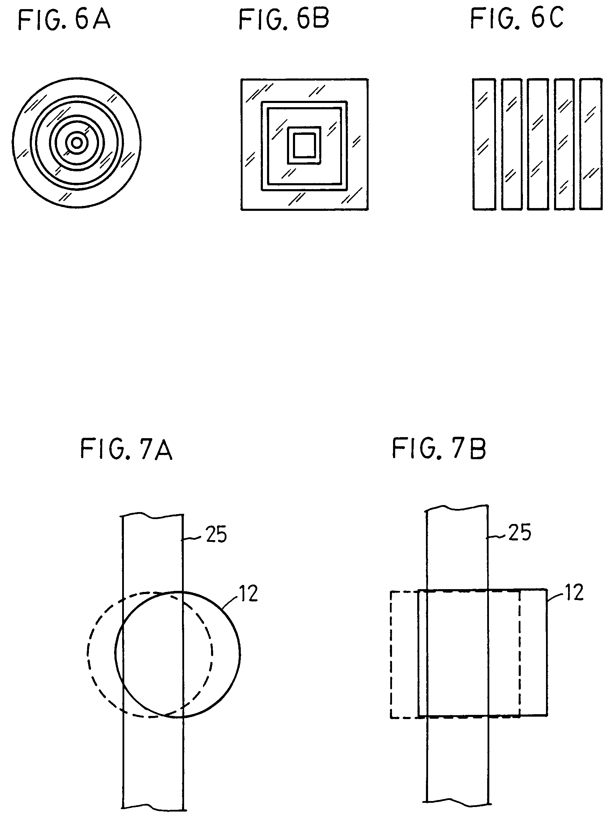

The liquid crystal device 17 is not limited specifically to the case of forming an arbitrary pattern by the matrix array of pixels but may also be applied to the case where concentric ring-shaped patterns are formed as shown in Fig. 6A and selectively controlled to be transparent and opaque to light and the quantity of light passing through each transparent pattern is controlled. Fig. 6B shows concentric square ring-like patterns and Fig. 6C parallel slit-like patterns.

For instance, in the case where the cross-section of the laser beam 12 is an ordinary circle as shown in Fig. 7A, if its center coincides with that of a link 25 as indicated by the broken line, then there is no problem in cutting the link 25. If the laser beam 12 deviates widthwise of the link 25 as indicated by the solid line, then the cutting length of the link 25 on one marginal portion thereof is smaller than the cutting length on the other marginal portion, and hence no good cutting is achieved. When the cross-section of the laser beam 12 is substantially square as shown in Fig. 7B, even if it deviates widthwise of the link 25 by the same distance as in the case of Fig. 7A as indicated by the solid line in Fig. 7B, the cutting length of the link 25 remains unchanged widthwise thereof, and hence good cutting is achieved.

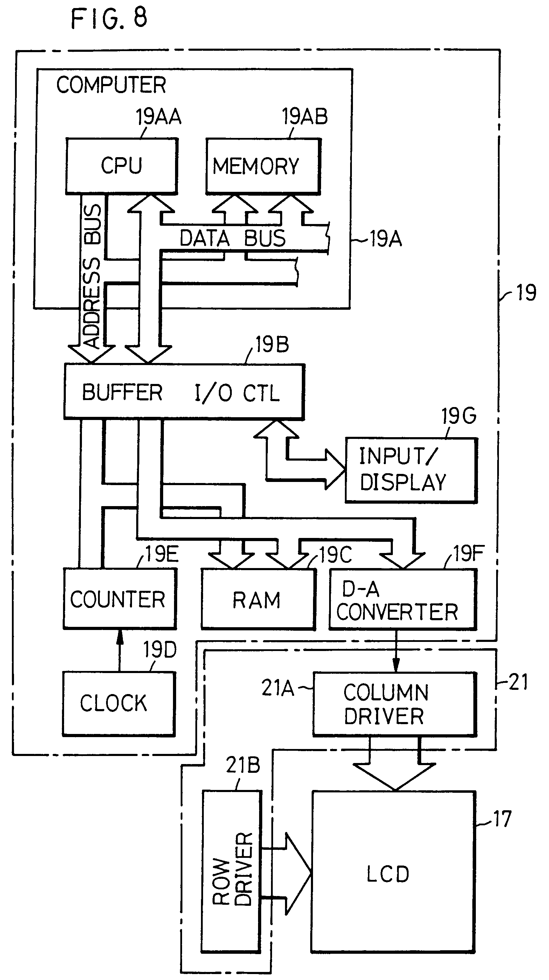

Fig. 8 illustrates examples of the drive circuit 21 of the liquid crystal device 17 and the liquid crystal control circuit 19 for controlling the drive circuit 21. The control circuit 19 comprises: a computer 19A including a CPU 19AA and a storage 19AB; an I/O control unit 19B for the computer 19A; a RAM 19C; a clock generator 19D and an address counter 19E for generating read addresses of the RAM 19C; a D/A converter 19F for converting image data to an analog image signal; and an input/display unit 19G into which an operator inputs an operation instruction of the device and which displays the execution of the instruction. The drive circuit 21 is made up of a column driver 21A which is supplied with the image signal from the D/A converter 19F and outputs it for each scanning line, and a row driver 21B which selectively drives scanning lines one by one.

In the storage 19AB of the computer 19A there are prestored, as image data, for example, the beam cross-sectional patterns shown in Figs. 6A, 6B and 6C and beam cross-sectional patterns which define other usable cross-sectional configurations and intensity distributions of the laser beam.

When an instruction for selecting a desired beam cross-sectional pattern is input by the operator through the input/display unit 19G, the CPU 19AA reads out image data of the selected cross-sectional pattern from the storage 19AB and writes it into the RAM 19C via the I/O control unit 19B. Upon completion of the write, the CPU 19AA resets the address counter 19R and then causes it to count clock pulses from the clock generator 19D, thus repeatedly generates read addresses in a sequential order. The read addresses thus produced are provided to the RAM 19C, from which pieces of image data of a selected one of the prestored beam cross-sectional patterns are sequentially read out and supplied to the D/A converter 19F. The image data of the beam cross-sectional pattern thus selected from the RAM 19C is repeatedly read out and displayed at a predetermined position on the liquid crystal element 17.

The beam cross-sectional pattern can be changed in the following manner. When the operator inputs again via the input/display unit 19G an instruction for selecting a desired beam cross-sectional pattern, the CPU 19AA reads out image data of the selected beam cross-sectional pattern from the storage 19AB and writes it into the RAM 19C. After this, the computer 19AA reads out the image data from the RAM 19C and repeatedly displays it on the liquid crystal device 17 at a predetermined location. Thus, the shape and intensity distribution of the laser beam for irradiating the workpiece 24 can be changed simply by reloading the RAM 19C with image data of a desired beam cross-sectional pattern, based on a select instruction from the input/display unit 19G.

As described above, according to the present invention, a liquid crystal device is disposed on the path of the laser beam and a beam cross-sectional pattern which defines a desired beam cross-sectional configuration and its light transmittance distribution can be selected and displayed. Accordingly, even in the course of machining one workpiece the cross-sectional configuration and intensity distribution of the laser beam can be changed momentarily through electrical control, and consequently, the present invention ensures efficient machining as compared with the prior art when such changes of the cross-sectional configuration and intensity distribution of the laser beam are involved.

It will be apparent that many modifications and variations may be effected without departing from the scope of the novel concepts of the present invention.

**Claims**

1. A laser machining device comprising:

a laser for emitting a laser beam;

liquid crystal light control means disposed on an optical path for irradiating a workpiece with said laser beam; and

liquid crystal control means for effecting control to display on said liquid crystal light control means a beam cross-sectional pattern having a desired configuration and a desired transmittance distribution.

2. The laser machining device of claim 1, wherein there are disposed on said optical path between said laser and said liquid crystal light control means expander means for enlarging the diameter of said laser beam for incidence to said liquid crystal light control means and a convergent lens whereby the diameter of said laser beam which has passed through said liquid crystal light control means is reduced for incidence to said workpiece.

3. The laser machining device of claim 1 or 2, wherein said liquid crystal control means includes: a storage for prestoring image data of beam cross-sectional patterns defining beam cross-sectional configurations and intensity distributions; a RAM for storing said image data of that one of said beam cross-sectional patterns which is to be displayed on said liquid crystal light control means; write control means for selecting a desired one of said prestored beam cross-sectional patterns and for writing it into said RAM; and beam cross-sectional pattern readout means for reading out said image data of said beam cross-sectional pattern from said RAM to display said read-out image data on said liquid crystal light control means.

FIG.1   PRIOR ART

FIG.2   PRIOR ART

PRIOR ART

FIG.3A   FIG.3B   FIG.3C

## FIG. 4

## FIG. 5

FIG. 6A

FIG. 6B

FIG. 6C

FIG. 7A

FIG. 7B

FIG. 8